# EUROPÄISCHE PATENTSCHRIFT

(11) **EP 1 125 525 B1**
(45) Veröffentlichungstag und Bekanntmachung des Hinweises auf die Patenterteilung: **31.03.2004**
(21) Anmeldenummer: 01102001.3
(22) Anmeldetag: 30.01.2001
(51) Int. Cl.: A47B 88/04, H03K 17/968

(54) **Möbel mit einer motorbetriebenen Ausziehvorrichtung**
Piece of furniture with motor-driven slide-out device
Pièce de mobilier avec un dispositif de glissières motorisées

(30) Priorität: 14.02.2000 AT 2152000
(43) Veröffentlichungstag der Anmeldung: 22.08.2001
(73) Patentinhaber: Fulterer Gesellschaft m.b.H., 6890 Lustenau (AT)
(72) Erfinder: Fulterer, Manfred, 6890 Lustenau (AT); Rauch, Augustin, 6822 Schnifis (AT)
(74) Vertreter: Hofmann, Ralf U., Dr.

(56) Entgegenhaltungen:
- DE-A- 3 021 363
- DE-U- 8 912 722
- GB-A- 2 133 782
- GB-A- 2 328 781

## Beschreibung

Die Erfindung betrifft ein Möbel mit einer Schublade oder einem Schrankauszug und einer motorbetriebenen Ausziehvorrichtung, mit einem von einer Motorsteuerung angesteuerten Motor zum Aus- und Einfahren der Ausziehschiene der Schublade oder des Schrankauszuges, und einer Schalteinrichtung zum Starten und Stoppen des Aus- und Einfahrens der Schublade oder des Schrankauszuges.

Motorbetriebene Ausziehvorrichtungen werden üblicherweise bei Auszügen verwendet, welche mit relativ großen Lasten beladen sind, um die Bedienung zu vereinfachen. Insbesondere werden solche Ausziehvorrichtungen bei Hochschrankauszügen angewendet (siehe DE-U-89 12 722), es ist aber auch eine Verwendung bei Schubladenauszügen möglich, in denen schwere Gegenstände gelagert werden, beispielsweise bei einer Werkzeuglade einer Werkbank.

Bei einer bekannten motorbetriebenen Ausziehvorrichtung der eingangs genannten Art erfolgt die Betätigung des Auszuges über einen Schaltbügel, der am Sockel des Korpus des Hochschrankes angeordnet ist und fußbetätigbar ist. Bei einem ersten Antippen des Schaltbügels fährt der Hochschrankauszug komplett aus. Nach erneutem Antippen fährt der Auszug wieder ein. Nachteilig ist bei diesem Hochschrankauszug die schlechte Zugänglichkeit des Schaltbügels am Korpus des Hochschranks bei ausgefahrenem Auszug. Von vorne ist diese Betätigung bei ausgefahrenem Auszug praktisch nicht möglich. Der Benutzer muß sich daher seitlich am Auszug vorbei zum Korpus des Hochschranks begeben, um den Schaltbügel zu betätigen. Die seitliche Zugänglichkeit kann aber je nach Anwendungsfall, beispielsweise bei mehreren nebeneinander angeordneten Hochschränken, ebenfalls erschwert sein.

Aus der DE 23 29 342 A1 sind weiters mehrere über eine Steuereinrichtung ansteuerbare, auf Schienen verfahrbare Schränke bekannt. Zur Ansteuerung der Schränke ist an jedem dieser Schränke zumindest eine Licht-Sende-Empfangseinheit vorgesehen. Es sind somit bei der aus der DE 23 29 342 A1 bekannten Steuereinrichtung keine vieladrigen Hängekabel erforderlich, die den Bewegungen der Schränke folgen müssen. Allerdings ist eine Stromzufuhr zu den einzelnen Schränken erforderlich. Diese kann über die Fahrschienen oder mittels separat verlegter Stromschienen getätigt werden.

Aufgabe der Erfindung ist es, ein Möbel mit Ausziehvorrichtung der eingangs genannten Art bereitzustellen, bei der die Bedienungsfreundlichkeit verbessert ist und bei der der Montage- und Wartungsaufwand gering sind.

Erfindungsgemäß gelingt dies durch ein Möbel gemäß Anspruch 1.

Durch die erfindungsgemäße Schalteinrichtung kann das Betätigungsorgan am ausziehbaren Teil, entweder Schublade oder Schrankauszug, angeordnet werden. Bevorzugt ist dabei eine Anordnung an der Unterseite der Frontblende. Es wird dadurch eine ausgezeichnete Zugänglichkeit des Betätigungsorgans auch bei ausgezogenem Auszug erreicht, und zwar sowohl von vorne als auch von der Seite her. Durch die erfindungsgemäße Ausbildung der Schalteinrichtung werden keine zum ausziehbaren Teil verlaufende Kabel benötigt. Eine Kabelzuführung zu einem bewegten Teil würde einen hohen Herstellungsaufwand und einen relativ hohen Verschleiß durch die ständige Biegebelastung des Kabels zur Folge haben. Weiters ist bei der erfindungsgemäßen Schalteinrichtung keine Energiequelle im ausziehbaren Teil nötig, welche einen zusätzlichen Wartungsaufwand bedeuten würde bzw. im Fall ihres Aufbrauchs zu einem Funktionsausfall führen würde.

Weitere Vorteile und Einzelheiten der Erfindung werden im folgenden anhand des in der Zeichnung dargestellten Ausführungsbeispiels erläutert. In der Zeichnung zeigen:

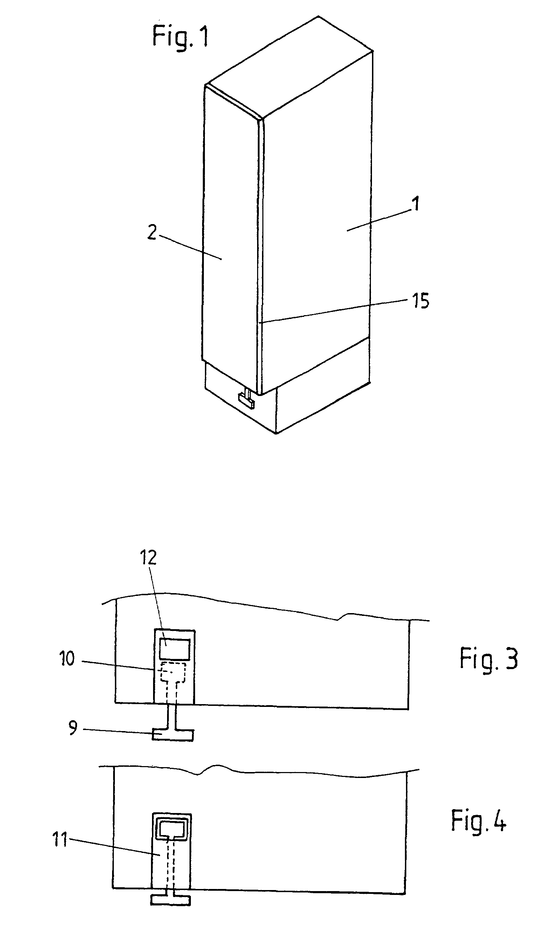

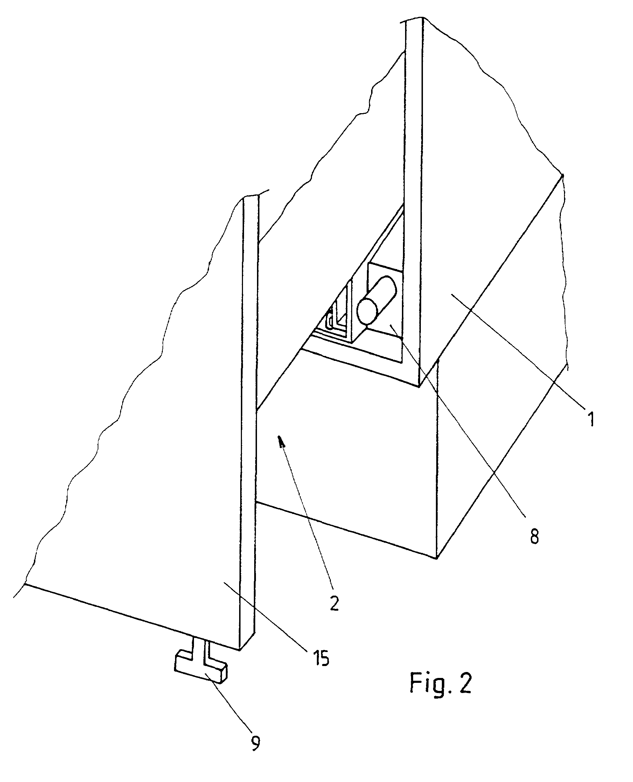

- Fig. 1: eine schaubildliche Darstellung eines erfindungsgemäßen Motorhochschranks;
- Fig. 2: eine vergrößerte Darstellung eines Teiles des Motorhochschranks bei teilweise geöffnetem Auszug;
- die Fig. 3 und 4: einen unteren Abschnitt der Blende des Auszugs in einer Ansicht von innen in den zwei Schaltstellungen des Betätigungsorgans und
- Fig. 5: eine schematische Prinzipdarstellung einer erfindungsgemäßen Ausziehvorrichtung.

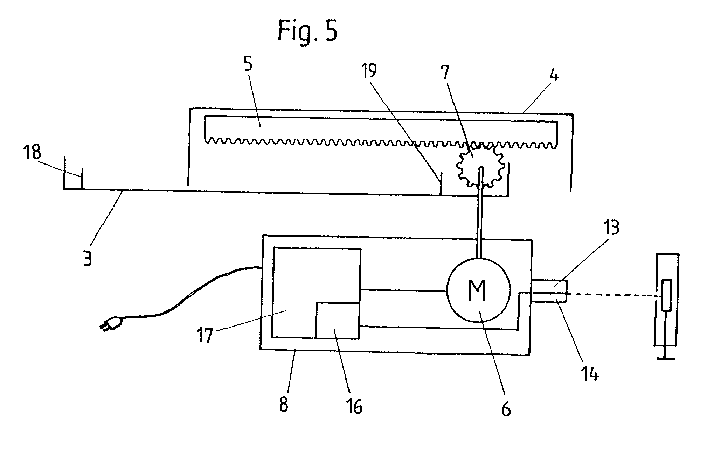

Die erfindungsgemäße Ausziehvorrichtung kann beispielsweise in Verbindung mit einem ausziehbaren Hochschrank eingesetzt werden, wie dies in den Figuren dargestellt ist. Aus dem Korpus 1 des Hochschranks ist ein Möbelteil 2 in Form eines Schrankauszugs ausziehbar, das beispielsweise auf einem Differentialauszug oder Teleskopauszug gelagert ist. Es kann dabei ein einzelner zentraler Auszug unter der Bodenplatte des Schrankauszugs vorgesehen sein. In Fig. 5 ist dieser der Einfachheit halber schematisch nur als Einfachauszug dargestellt mit einer Korpusschiene 3 und einer mit dem ausziehbaren Möbelteil verbundenen Ausziehschiene 4. An der Ausziehschiene 4 ist eine Zahnstange 5 befestigt, welche von einem Motor 6 über ein Ritzel 7 antreibbar ist. Im Falle der Ausbildung des Auszugs als Differentialauszug könnte die Zahnstange 5 auch an der Mittelschiene des Differentialauszugs angeordnet sein. Im Antriebsgehäuse 8 ist weiters eine den Motor 6 ansteuernde Motorsteuerung 17 untergebracht.

Zum Starten und Stoppen des Aus- und Einfahrens des Auszugs durch den Benutzer ist eine Schalteinrichtung vorgesehen, welche ein Betätigungsorgan 9 umfaßt. Das Betätigungsorgan 9 ist mit einem Lichtreflektor 10 verbunden, der über das Betätigungsorgan längsverschiebbar ist. In der Ruheposition des Betätigungsorgans 9 ist der Lichtreflektor 10 hinter einer Blende oder Abdeckung 11 angeordnet. Wird das Betätigungsorgan 9 nach oben verschoben, so kommt der Lichtreflektor 10 in einem Fenster 12 der Abdeckung 11 zu liegen und reflektiert das von einem Lichtsender 13 abgestrahlte Licht auf einen Lichtempfänger 14. Lichtsender 13 und Lichtempfänger 14 sind an der der Frontblende 15 zugewandten Vorderseite des Antriebsgehäuses 8 angeordnet. Das Betätigungsorgan 9 ragt an der Unterseite der Frontblende 15 über diese vor und kann vom Benutzer fußbetätigt werden. Der Lichtreflektor 10 ist an der Innenseite der Frontblende 15 angeordnet. Der Lichtsender 13 ist bevorzugterweise ein Infrarotsender, kann aber auch beispielsweise eine Laserdiode sein. Der Lichtempfänger ist an das vom Lichtsender ausgestrahlte Licht angepaßt.

Wenn vom Lichtempfänger 14 vom Lichtreflektor 10 reflektiertes Licht empfangen wird, so wird dieses Signal an die Schaltsteuerung 16 der Motorsteuerung 17 weitergegeben. Ein empfangener Impuls ändert den Schaltzustand. Es wird dabei zwischen den Schaltzuständen "Ausfahren", "Stop", "Einfahren", "Stop", "Ausfahren", ...... gewechselt, und zwar erfolgt ein derartiger Wechsel des Schaltzustandes bei jeder Betätigung des Betätigungsorgans 9. Ein Wechsel zwischen den Schaltzuständen "Ausfahren" bzw. "Einfahren" und dem Schaltzustand "Stop" wird weiters durch eine Momentbegrenzungseinrichtung der Motorsteuerung 17 durchgeführt, beispielsweise bei einem Auftreffen der Frontblende 15 auf ein Hindernis oder bei einem Auftreffen der Ausziehschiene 4 auf einen der in Fig. 5 symbolisch dargestellten Anschläge 18, 19 bei Erreichen der Endposition im eingefahrenen oder ausgefahrenen Zustand.

Weiters wäre es auch denkbar und möglich, daß bei einer Betätigung des Betätigungsorgans 9 bei gerade ausfahrendem oder einfahrendem Auszug nicht der Schaltzustand "Stop", sondern unmittelbar der Schaltzustand mit einer umgekehrten Drehrichtung des Motors 6 eingenommen wird. Anstelle des dargestellten längsverschiebbaren Betätigungsorgans 9 könnte beispielsweise auch ein verschwenkbarer Hebel vorgesehen sein, an dessen anderem Hebelarm der Lichtreflektor 10 befestigt ist. Auch ein mit dem Lichtreflektor 10 verbundener Drehgriff könnte vorgesehen sein, über den der Lichtreflektor um eine Achse verdrehbar ist, die in der Reflektorebene liegt. Auch dadurch könnte der vom Lichtsender 13 ausgesandte Lichtstrahl bei einer Betätigung des Drehgriffes auf den Lichtempfänger 14 reflektiert werden und andernfalls von diesem Lichtempfänger 14 abgelenkt werden.

Lichtsender 13 und Lichtempfänger 14 werden von der Schaltsteuerung 16 vorteilhafterweise gepulst angesteuert, wie dies von herkömmlichen Lichtschranken bekannt ist, um eine Fehlfunktion durch Streulicht zu vermeiden.

## Patentansprüche

1. Möbel mit einer Schublade oder einem Schrankauszug (2) und einer motorbetriebenen Ausziehvorrichtung mit einem von einer Motorsteuerung (17) angesteuerten Motor (6) zum Aus- und Einfahren der Ausziehschiene (4) der Schublade oder des Schrankauszuges (2), und einer Schalteinrichtung zum Starten und Stoppen des Aus- und Einfahrens der Schublade oder des Schrankauszuges (2), **dadurch gekennzeichnet, dass** die Schalteinrichtung einen Lichtsender (13), einen Lichtempfänger (14) sowie einen an der Schublade oder am Schrankauszug (2) angeordneten Lichtreflektor (10) umfasst, der mit einem vom Benutzer betätigbaren Betätigungsorgan (9) verbunden ist und über das Betätigungsorgan (9) zwischen einer ersten Stellung, in der das vom Lichtsender (13) ausgesandte Licht vom Lichtreflektor (10) auf den Lichtempfänger (14) reflektiert wird, und einer zweiten Stellung, in der das vom Lichtsender (13) ausgesandte Licht nicht auf den Lichtempfänger (14) reflektiert wird, verstellbar ist, wobei mittels des Betätigungsorgans (9) das Ausfahren und das Einfahren der Schublade oder des Schrankauszugs (2) bedienbar ist.

2. Möbel nach Anspruch 1, **dadurch gekennzeichnet, dass** der Lichtreflektor (10) vom Betätigungsorgan (9) linear verschiebbar ist oder am freien Ende eines Hebelarms eines Schwenkhebels angeordnet ist.

3. Möbel nach Anspruch 1 oder Anspruch 2, **dadurch gekennzeichnet, dass** in der zweiten Stellung des Lichtreflektors (10) dieser von einer Abdeckung (11) abgedeckt ist.

4. Möbel nach Anspruch 1, **dadurch gekennzeichnet, dass** der Lichtreflektor (10) um eine in der Reflektorebene liegende Achse verschwenkbar ist.

5. Möbel nach einem der Ansprüche 1 bis 4, **dadurch gekennzeichnet, dass** die Schalteinrichtung so ausgebildet ist, dass bei einer ersten Betätigung des Betätigungsorgans (9) im ausgeschalteten Zustand des Motors (6) die Motorsteuerung (17) den Motor (6) in die eine Richtung startet, bei einer weiteren Betätigung des Betätigungsorgans (9) die Motorsteuerung (17) den Motor (6) stoppt, bei einer weiteren Betätigung des Betätigungsorgans (9) die Motorsteuerung (17) den Motor (6) in die andere Richtung startet und bei einer weiteren Betätigung des Betätigungsorgans (9) die Motorsteuerung (17) den Motor (6) wiederum stoppt.

6. Möbel nach einem der Ansprüche 1 bis 5, **dadurch gekennzeichnet, dass** die Motorsteuerung (17) eine Drehmomentbegrenzungseinrichtung umfasst, wobei bei einer Überschreitung des maximalen Drehmoments des Motors (6) die Motorsteuerung (17) den Motor (6) stoppt.

7. Möbel nach einem der Ansprüche 1, bis 6, **dadurch gekennzeichnet, dass** der Lichtreftektor (10) an der Innenseite der Frontblende (15) der Schublade oder des Schrankauszuges (2) angeordnet ist.

8. Möbel nach einem der Ansprüche 1 bis 7, **dadurch gekennzeichnet, dass** das Betätigungsorgan (9) an der Unterkante der Frontblende (15) der Schublade oder des Schrankauszuges (2) über diese vorsteht.

## Claims

1. An item of furniture with a drawer or with a cupboard pull-out (2) and with a motorised pull-out device, with a motor (6) controlled by a motor control unit (17) for extending and retracting the pull-out rail (4) of the drawer or of the cupboard pull-out (2), and with a switching device for starting and stopping the extension and retraction of the drawer or of the cupboard pull-out (2), **characterised in that** the switching device comprises a light transmitter (13), a light receiver (14), and a light reflector (10) arranged on the drawer or the cupboard pull-out (2), which light reflector is connected to an actuating element (9) that can be actuated by the user, and which light reflector can be adjusted by means of the actuating element (9) between a first position, in which the light emitted by the light transmitter (13) is reflected by the light reflector (10) onto the light receiver (14), and a second position, in which the light emitted by the light transmitter (13) is not reflected onto the light receiver (14), the actuating element (9) enabling the extension and retraction of the drawer or of the cupboard pull-out (2) to be operator-controlled.

2. An item of furniture according to claim 1, **characterised in that** the light reflector (10) can be moved linearly by the actuating element (9) or is arranged on the free end of a lever arm of a pivoted lever.

3. An item of furniture according to claim 1 or claim 2, **characterised in that** in the second position of the light reflector (10) the said light reflector is covered by a cover (11).

4. An item of furniture according to claim 1, **characterised in that** the light reflector (10) can be pivoted about an axis that lies in the reflector plane.

5. An item of furniture according to any one of claims 1 to 4, **characterised in that** the switching device is designed so that, when the actuating element (9) is first actuated with the motor (6) switched off, the motor control unit (17) starts the motor (6) in the one direction, when the actuating element (9) is further actuated the motor control unit (17) stops the motor (6), when the actuating element (9) is further actuated the motor control unit (17) starts the motor (6) in the other direction, and when the actuating element (9) is further actuated the motor control unit (17) stops the motor (6) again.

6. An item of furniture according to any one of claims 1 to 5, **characterised in that** the motor control unit (17) comprises a torque limiting means, the motor control unit (17) stopping the motor (6) when the maximum torque of the motor (6) is exceeded.

7. An item of furniture according to any one of claims 1 to 6, **characterised in that** the light reflector (10) is arranged on the inside of the front panel (15) of the drawer or of the cupboard pull-out (2).

8. An item of furniture according to any one of claims 1 to 7, **characterised in that** the actuating element (9) on the lower edge of the front panel (15) of the drawer or of the cupboard pull-out (2) projects beyond the said front panel.

## Revendications

1. Meuble comprenant un tiroir ou un rack extractible (2) et un dispositif d'extraction motorisé, avec un moteur (6) commandé par une commande de moteur (17) pour sortir et rentrer le rail d'extraction (4) du tiroir ou du rack extractible (2), et avec un dispositif de commutation pour démarrer et stopper la sortie et la rentrée du tiroir ou du rack (2),
**caractérisé en ce que**
le dispositif de commutation comprend un émetteur de lumière (13) et un récepteur de lumière (14), ainsi qu'un réflecteur de lumière (10) disposé au niveau du tiroir ou du rack (2), et relié à un organe d'actionnement (9) pouvant être actionné par l'utilisateur, et l'organe d'actionnement (9), règle le réflecteur entre une première position dans laquelle la lumière émise par l'émetteur de lumière (13) est réfléchie par le réflecteur de lumière (10) sur le récepteur de lumière (14), et une deuxième position, dans laquelle la lumière émise par l'émetteur de lumière (13) n'est pas réfléchie par le réflecteur de lumière (10), l'organe d'actionnement (9) permettant de sortir et de rentrer le tiroir ou le rack (2).

2. Meuble selon la revendication 1,
**caractérisé en ce que**
le réflecteur de lumière (10) peut être déplacé de manière linéaire par l'organe d'actionnement (9) ou disposé au niveau de l'extrémité libre d'un bras de levier d'un levier pivotant.

3. Meuble selon la revendication 1 ou la revendication 2,
**caractérisé en ce que**
dans la deuxième position du réflecteur de lumière (10) celui-ci est recouvert par un cache (11).

4. Meuble selon la revendication 1,
**caractérisé en ce que**
le réflecteur de lumière (10) est pivotant autour d'un axe situé dans le plan du réflecteur.

5. Meuble selon l'une quelconque des revendications 1 à 4,
**caractérisé en ce que**
le dispositif de commutation est configuré de telle sorte que lors d'un premier actionnement de l'organe d'actionnement (9), à l'état coupé du moteur (6), la commande de moteur (17) démarre le moteur (6) dans une direction, et lors d'un actionnement suivant de l'organe d'actionnement (9) la commande de moteur (17) stoppe le moteur (6), et lors d'un actionnement suivant de l'organe d'actionnement (9) la commande de moteur (17) démarre le moteur (6) dans l'autre direction et lors d'un actionnement suivant de l'organe d'actionnement (9) la commande de moteur (17) stoppe à nouveau le moteur (6).

6. Meuble selon l'une quelconque des revendications 1 à 5,
**caractérisé en ce que**
la commande de moteur (17) comprend un dispositif limiteur du couple de rotation, la commande de moteur (17) stoppant le moteur (6) en cas de dépassement du couple du rack extractible (6).

7. Meuble selon l'une quelconque des revendications 1 à 6,
**caractérisé en ce que**
le réflecteur de lumière (10) est disposé sur la face intérieure de l'écran frontal (15) du tiroir ou du rack extractible (2).

8. Meuble selon l'une quelconque des revendications 1 à 7,
**caractérisé en ce que**
l'organe d'actionnement (9) est disposé en saillie par rapport au bord inférieur de l'écran frontal (15) du tiroir ou du rack extractible (2).
